(19) Europäisches Patentamt / European Patent Office / Office européen des brevets

(11) **EP 3 291 443 B1**

## (12) EUROPEAN PATENT SPECIFICATION

(45) Date of publication and mention
of the grant of the patent:
**12.02.2020 Bulletin 2020/07**

(51) Int Cl.:
*H03F 3/00* *(2006.01)*     *G11C 27/02* *(2006.01)*
*H03F 3/45* *(2006.01)*     *H03M 1/44* *(2006.01)*

(21) Application number: **16186820.3**

(22) Date of filing: **01.09.2016**

(54) **DIFFERENTIAL GAIN-STAGE CIRCUIT AND METHOD FOR MULTIPLYING A VOLTAGE**

DIFFERENTIELLE VERSTÄRKUNGSEBENENSCHALTUNG UND VERFAHREN ZUR
VERVIELFACHUNG EINER SPANNUNG

CIRCUIT D'ÉTAGE DE GAIN DIFFÉRENTIEL ET PROCÉDÉ DE MULTIPLICATION D'UNE TENSION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.03.2018 Bulletin 2018/10**

(73) Proprietor: **ams AG**
**8141 Premstätten (AT)**

(72) Inventor: **Siegl, Inge**
**8010 Graz (AT)**

(74) Representative: **Epping - Hermann - Fischer**
**Patentanwaltsgesellschaft mbH**
**Schloßschmidstraße 5**
**80639 München (DE)**

(56) References cited:
**JP-A- 2013 207 697     US-A1- 2010 237 710
US-B1- 7 724 063     US-B1- 8 299 837**

**Description**

The patent application is related to a differential gain-stage circuit and to a method for multiplying a voltage.

A gain-stage circuit is commonly used for multiplying a voltage. An input voltage is provided to an input terminal of the gain-stage circuit and a multiplied voltage is provided as an output voltage at an output terminal of the gain-stage circuit. The gain-stage circuit may comprise a switched capacitor network. Such a gain-stage circuit can be a part of a multiplying digital-to-analog converter, abbreviated MDAC. A pipelined analog-to-digital converter, abbreviated pipelined AD converter, can comprise such a MDAC.

Document US 2010/0237710 A1 describes a passive differential voltage doubler. The voltage doubler comprises a first and a second capacitor each having a first and a second electrode. In a charging phase, a first input voltage is provided via a switch to the first electrode of the first capacitor and via a further switch to the second electrode of the second capacitor. Moreover, a second input voltage is provided via another switch to the second electrode of the first capacitor and via an additional switch to the first electrode of the second capacitor.

Document US 8,299,837 B1 refers to an integrator-based common mode stabilization method applied to a pseudo-differential switched-capacitor circuit. A circuit comprises a first amplifier and a first capacitor that couples an output of the first amplifier to an input of the first amplifier. The circuit comprises a second amplifier and a second capacitor that couples an output of the second amplifier to an input of the second amplifier. Differential input voltages are applied to the circuit. When a control signal sets some of the switches of the circuit in a conducting state, the two electrodes of the first capacitor are connected to an output signal of the circuit and a common mode reference voltage and also the two electrodes of the second capacitor are connected to the output signal of the circuit and the common mode reference voltage.

Document US 7724063 B1 is related to an integrator-based common-mode stabilization technique for pseudo-differential switched-capacitor circuits. A positive input terminal is coupled via switches to first electrodes of a first and of a second capacitor. Second electrodes of the first and of the second capacitor are coupled to an input of a first amplifier. A negative input terminal is coupled via switches to first electrodes of a third and of a fourth capacitor. Second electrodes of the third and of the fourth capacitor are coupled to an input of a second amplifier.

Document JP 2013-207697 A describes a sample hold circuit. The circuit comprises a first and a second circuit input, a first and a second capacitor and a differential amplifier with two inputs and with two outputs. In a first phase, a first electrode of the first capacitor and a second electrode of the second capacitor are both connected to the first circuit input and a second electrode of the first capacitor and a first electrode of the second capacitor are both connected to the second circuit input. The first electrode of the first capacitor is connected to the first input of the differential amplifier and the first electrode of the second capacitor is connected to the second input of the differential amplifier.

It is an object of the present patent application to provide a differential gain-stage circuit and a method for multiplying a voltage that can be used for a differential input voltage.

This object is solved by the subject matter of the independent claims. Further developments and embodiments are described in the dependent claims.

In an embodiment, a differential gain-stage circuit comprises a positive and a negative input terminal, a first capacitor with a first and a second electrode, a second capacitor with a first and a second electrode, a first amplifier with an input coupled to the first electrode of the first capacitor, a second amplifier with an input coupled to the first electrode of the second capacitor, a positive output terminal coupled to an output of the first amplifier and a negative output terminal coupled to an output of the second amplifier. In a first phase, a parallel circuit of the first and the second capacitor is connected to the positive and the negative input terminal.

The first electrode of the first capacitor is directly and permanently connected to the input of the first amplifier. The first electrode of the second capacitor is directly and permanently connected to the input of the second amplifier.

Advantageously, a differential input voltage can be applied to the positive and the negative input terminal resulting in a differential output voltage that is tapped at the positive and the negative output terminal.

In an embodiment, the first and the second amplifier are implemented as a first and a second buffer. The first and the second amplifier comprise an input and an output. The gains of the first and the second amplifier may be one. Thus, the first and the second amplifier may be implemented as a first and a second unity gain buffer. The first and the second amplifier may each have exactly one input and exactly one output.

In an alternative embodiment, the first and the second amplifier are implemented as a first and a second operational amplifier. The gains of the first and the second amplifier may be one. The first and the second amplifier may each have an input, a further input and an output.

In an embodiment, in the first phase, the first electrode of the first capacitor and the second electrode of the second capacitor are both connected to the positive input terminal. The second electrode of the first capacitor and the first electrode of the second capacitor are both connected to the negative input terminal.

In an embodiment, the differential gain-stage circuit comprises a first and a second input switch coupling the positive and the negative input terminal to the first and the second electrode of the first capacitor. Moreover, a third and a fourth input switch of the differential gain-stage circuit couple the positive and the negative input terminal to the first and the second electrode of the second capacitor.

In an embodiment, the first input switch couples the positive input terminal to the first electrode of the first capacitor. The second input switch couples the negative input terminal to the second electrode of the first capacitor. The third input switch couples the negative input terminal to the first electrode of the second capacitor. The fourth input switch couples the positive input terminal to the second electrode of the second capacitor.

In an embodiment, the first to the fourth input switch are set in a conducting state in the first phase and in a non-conducting state in a second phase. The second phase follows the first phase. The first and the second phase may alternate. The first and the second phase may alternate periodically.

In an embodiment, the differential gain-stage circuit comprises a first voltage node connected to the second electrode of the first capacitor and a second voltage node connected to the second electrode of the second capacitor. In a second phase, a first adder voltage is provided to the first voltage node and a second adder voltage is provided to the second voltage node. The first adder voltage may be different from the second adder voltage.

In an embodiment, the differential gain-stage circuit comprises a digital-to-analog converter, abbreviated DA converter. The DA converter includes outputs coupled to the first and the second voltage node. The DA converter generates the first and the second adder voltage in the second phase. The DA converter may have open outputs in the first phase. The outputs of the DA converter may be in a high-impedance state in the first phase.

In an embodiment, the digital-to-analog converter comprises a first to a fourth converter switch, a positive reference terminal and a negative reference terminal. The positive reference terminal is coupled via the first converter switch to the first voltage node and via the second converter switch to second voltage node. The negative reference terminal is coupled via the third converter switch to the first voltage node and via the fourth converter switch to the second voltage node.

In an embodiment, the digital-to-analog converter comprises a fifth and a sixth converter switch and a common mode terminal coupled via the fifth converter switch to the first voltage node and via the sixth converter switch to the second voltage node.

In an embodiment, the first to the sixth converter switch are set in a non-conducting state in the first phase. The first to the sixth converter switch may only be set in a conducting state in the second phase. One of the first, third and fifth converter switch and one of the second, fourth and sixth converter switch are set in a conducting state in the second phase; the other converter switches are set in a non-conducting state in the second phase.

In an embodiment, the differential gain-stage circuit realizes a gain factor of approximately two. The gain factor of the differential gain-stage circuit may be in the range of 1.8 to 2.1 or 1.85 to 1.96 or 1.9 to 2.0. The gain factor is the ratio between a differential output voltage and a differential input voltage.

In an embodiment, a multiplying digital-to-analog converter comprises the differential gain-stage circuit and an analog-to-digital converter, abbreviated AD converter. An analog input of the multiplying digital-to-analog converter is coupled to the positive and the negative input terminal of the differential gain-stage circuit and to an input of the AD converter. An output of the AD converter is coupled to an input of the digital-to-analog converter of the differential gain-stage circuit and to a digital output of the multiplying digital-to-analog converter. The positive and the negative output terminal of the differential gain-stage circuit are coupled to an analog output of the multiplying digital-to-analog converter.

In an embodiment, a pipelined analog-to-digital converter arrangement, abbreviated pipelined AD converter arrangement, comprises a first number N of stages. At least one stage of the first number N of stages is implemented as the multiplying digital-to-analog converter.

The differential gain-stage circuit for a multiplying digital-to-analog converter, abbreviated MDAC, in a pipelined AD converter arrangement makes use of a differential signal, especially the differential input signal.

Advantageously, a gain of two is created with a switched capacitor network. The differential gain-stage circuit is implemented as a switched capacitor network. In particular, the differential gain-stage circuit implements the gain in a differential 1.5-bit MDAC in the pipelined AD converter arrangement.

Advantageously, the gain of two is implemented by a switched capacitor network and the use of only two amplifiers which may be realized as two unity gain buffers. Thus, it is avoided to consume a high amount of power due to a large number of operational amplifiers. Furthermore, the requirement for matching of the first and the second capacitor that are the sampling capacitors is low. The differential gain-stage circuit implements the gain using the differential input voltage.

In an embodiment, the influence of parasitic capacitances, in particular the bottom plate capacitances of the first and the second capacitor, is kept low. Advantageously, the parasitic capacitances only result in a small error. This positive effect can mainly be observed at low values of the parasitic capacitances.

In an embodiment, a first and a second channel of the differential x2 gain-stage circuit each comprises: a sampling capacitor, two sampling switches, at least one switch for the voltage to be added (for a simple gain of two without offset, this voltage might be chosen equal to the common mode voltage of the input signals), and an amplifier, to minimize the load on the sampling capacitor when the signal needs to be forwarded.

The differential x2 gain-stage can be used as a MDAC for a 1-bit pipelined AD converter stage, wherein three switches are necessary to implement the digital-to-analog converter of the stage.

Advantageously, the impact of the bottom plate capacitance is eliminated. A high gain accuracy may be achieved. Less components are used. Thus, the complexity of the circuit is kept low. The area occupied by sampling capacitors is kept low. The differential gain-stage circuit operates as a charge pump. An effective capacitance towards the voltage divider with the input capacitance of the amplifier is large. The charge redistribution is kept small. Matching of the sampling capacitors has no first order effect on the gain accuracy.

In an embodiment, a method for multiplying a voltage comprises providing a differential input voltage to a parallel circuit of a first capacitor and a second capacitor in a first phase, generating a positive output voltage by a first amplifier having an input coupled to the first electrode of the first capacitor, and generating a negative output voltage by a second amplifier having an input coupled to the first electrode of the second capacitor.

Advantageously, a differential input voltage can be applied both to the first capacitor and to the second capacitor resulting in the positive and the negative output voltage. Thus, a differential output voltage is provided from subtracting the negative output voltage from the positive output voltage.

In an embodiment, a first adder voltage is provided to the second electrode of the first capacitor and a second adder voltage is provided to the second electrode of the second capacitor in a second phase.

In an embodiment, the parallel circuit of the first and the second capacitor is realized by connecting the first electrode of the first capacitor to the second electrode of the second capacitor and by connecting the second electrode of the first capacitor to the first electrode of the second capacitor.

The following description of figures of exemplary embodiments may further illustrate and explain aspects of the application. Devices and circuit parts with the same structure and the same effect, respectively, appear with equivalent reference symbols. As far as devices or circuit parts correspond to one another in terms of their function in different figures, the description thereof is not repeated for each of the following figures.

Figures 1A to 1D    show an exemplary embodiment of a differential gain-stage circuit and the corresponding phases and signals.

Figure 2A and 2B    show a further exemplary embodiment of a differential gain-stage circuit and the corresponding phases.

Figure 3    shows an exemplary embodiment of a multiplying digital-to-analog converter.

Figure 4    shows an exemplary embodiment of a pipelined analog-to-digital converter arrangement.

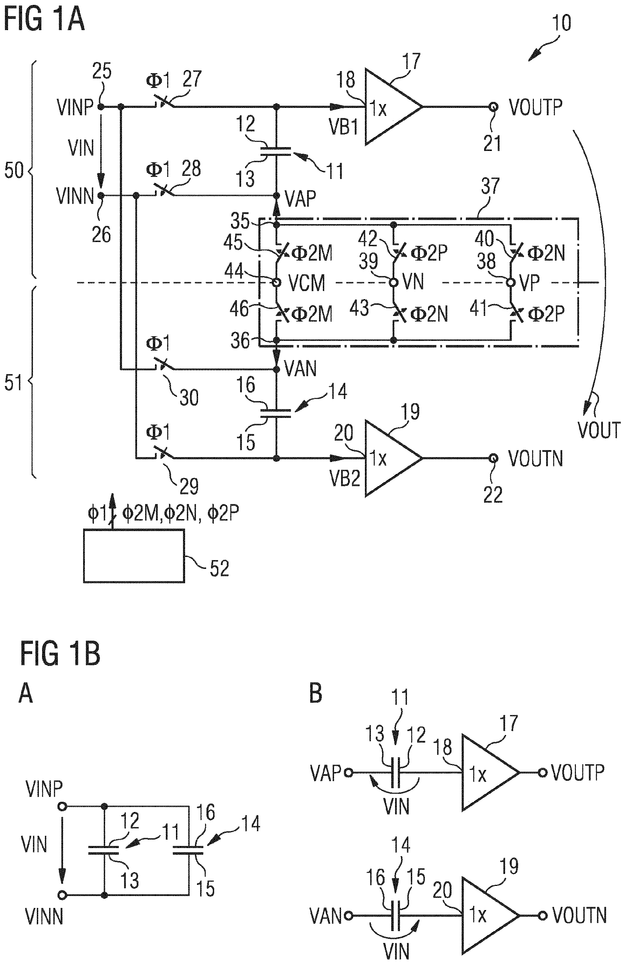

Figure 1A shows an exemplary embodiment of a differential gain-stage circuit 10 comprising a first capacitor 11 with a first and a second electrode 12, 13 and a second capacitor 14 with a first and a second electrode 15, 16. Moreover, the differential gain-stage circuit 10 comprises a first amplifier 17 with an input 18 and a second amplifier 19 with an input 20. The first electrode 12 of the first capacitor 11 is directly and permanently connected to the input 18 of the first amplifier 17. Correspondingly, the first electrode 15 of the second capacitor 14 is directly and permanently connected to the input 20 of the second amplifier 19. A positive output terminal 21 of the differential gain-stage circuit 10 is directly connected to an output of the first amplifier 17. Similarly, a negative output terminal 22 of the differential gain-stage circuit 10 is directly connected to an output of the second amplifier 19. The first amplifier 17 and the second amplifier 19 may be realized identical.

The first and the second amplifier 17, 19 are realized as buffers, optionally as unity gain buffers. The first and the second amplifier 17, 19 may be both configured as source follower. For example, the first and the second amplifier 17, 19 may be both implemented as p-channel metal-oxide-semiconductor source follower or may be both implemented as n-channel metal-oxide-semiconductor source follower.

Additionally, the differential gain-stage circuit 10 comprises a positive and a negative input terminal 25, 26. The differential gain-stage circuit 10 comprises a first to a fourth input switch 27 to 30. The positive input terminal 25 is coupled via the first input switch 27 to the first electrode 12 of the first capacitor 11. The negative input terminal 26 is coupled via the second input switch 28 to the second electrode 13 of the first capacitor 11. Moreover, the negative input terminal 26 is coupled via the third input switch 29 to the first electrode 15 of the second capacitor 14. The positive input terminal 25 is coupled via the fourth input switch 30 to the second electrode 16 of the second capacitor 14.

The differential gain-stage circuit 10 comprises a first voltage node 35 that is directly and permanently connected to the second electrode 13 of the first capacitor 11. A second voltage node 36 is directly and permanently connected to the second electrode 16 of the second capacitor 14.

Additionally, the differential gain-stage circuit 10 comprises a digital-to-analog converter 37, abbreviated DA converter. The DA converter 37 comprises a positive and a negative reference terminal 38, 39 that are both coupled to the first and the second voltage node 35, 36. Thus, the DA converter 37 comprises a first to a fourth converter switch 40 to 43. The first converter switch 40 couples the positive reference terminal 38 to the first voltage node 35. Correspondingly, the second converter switch 41 couples the positive reference terminal 38 to the second voltage node 34. The third converter switch 42 couples the negative reference terminal 39 to the first voltage node 35 and the fourth converter switch 43 couples the negative reference terminal 39 to the second voltage node 36.

Moreover, the DA converter 37 comprises a common mode terminal 44 that is coupled to the first and the second voltage node 35, 36. A fifth converter switch 45 of the DA converter 37 couples the common mode terminal 44 to the first voltage node 35. Additionally, a sixth converter switch 46 of the DA converter 37 couples the common mode terminal 44 to the second voltage node 36.

The differential gain-stage circuit 10 comprises a control logic 52 having outputs connected to the control terminals of the first to the fourth input switch 27 to 30. Moreover, further output terminals of the control logic 52 may be connected to the control terminals of the first to the sixth converter switch 40 to 43, 45, 46.

The first and the second capacitor 11, 14 have approximately the same capacitance value CS. The first capacitor 11 and the first amplifier 17 are part of a first channel 50 that can be named p-channel or positive side channel. The second capacitor 14 and the second amplifier 19 are part of a second channel 51 that can be named n-channel or negative side channel.

A positive input voltage VINP is provided to the positive input terminal 25. A negative input voltage VINN is applied to the negative input terminal 26. Thus, a differential input voltage VIN can be tapped between the positive input terminal 25 and the negative input terminal 26. A positive output voltage VOUTP is generated by the first amplifier 17 and can be tapped at the positive output terminal 21. A negative output voltage VOUTN is generated by the second amplifier 19 and can be tapped at the negative output terminal 22. A differential output voltage VOUT is tapped between the positive and the negative output terminal 21, 22.

In each channel 50, 51, only one capacitor 11, 14 may be needed to create the gain, exploiting the fact that the voltage difference needed is already present in a differential system. The voltage difference is the differential input voltage VIN.

Thus, a first input voltage VB1 is provided to the input 18 of the first amplifier 17. A second input voltage VB2 is applied to the input 20 of the second amplifier 19. The first and the second amplifier 17, 19 may have an amplification factor of one. Thus, the first input voltage VB1 is equal to the positive output voltage VOUTP. The second input voltage VB2 is equal to the negative output voltage VOUTN. A positive reference voltage VP is provided at the positive reference terminal 38 and a negative reference voltage VN is provided at the negative reference terminal 39. A common mode voltage VCM is provided at the common mode terminal 44. The differential gain-stage circuit 10 may comprise a not-shown reference source coupled to the positive and the negative reference terminal 38, 39 and to the common mode terminal 44 generating the positive and the negative reference voltage VP, VN and the common mode voltage VCM.

The first to the fourth input switch 27 to 30 are each controlled by the same signal namely a first control signal Φ1. The second and the third converter switch 41, 42 are controlled by a first converter signal Φ2P. The first and the fourth converter switch 40, 43 are controlled by a second converter signal Φ2N. The fifth and the sixth converter switch 45, 46 are both controlled by a third converter signal Φ2M. The first control signal Φ1 and the first to the third converter signals Φ2P, Φ2N, Φ2M are generated by the control logic 52.

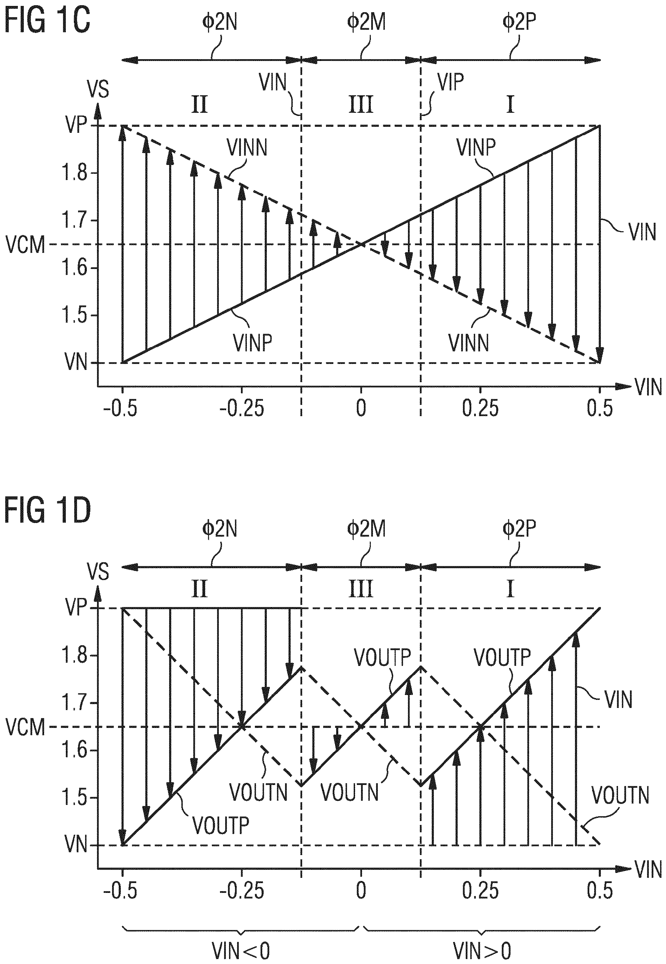

In Figure 1A, a schematic of the differential circuit is illustrated with the converter signals Φ2M, Φ2N, Φ2P according to Figure 1C and 1D. The converter signals Φ2M, Φ2N, Φ2P may be named clock phases.

Figure 1B shows exemplary phases of the differential gain-stage circuit 10 shown in Figure 1A. In Figure 1B, the method of the differential gain topology is explained. In a first phase A, the first to the fourth input switch 27 to 30 are set in a conducting state by the first control signal Φ1. Thus, the positive input voltage VINP is provided to the first electrode 12 of the first capacitor 11 and to the second electrode 16 of the second capacitor 14. Correspondingly, the negative input voltage VINN is applied to the second electrode 13 of the first capacitor 11 and to the first electrode 15 of the second capacitor 14. The converter switches 40 to 43, 45, 46 are set in a non-conducting state in the first phase A. Thus, the differential input voltage VIN is applied across the first capacitor 11 and the second capacitor 14. The first phase A can be named sampling phase.

A second phase B follows the first phase A. The second phase B can be named amplification phase. In the second phase B, a first adder voltage VAP is provided to the first voltage node 35 and a second adder voltage VAN is provided to the second voltage node 36. Thus, the input voltage VB1 of the first amplifier 17 and the input voltage VB2 of the second amplifier 19 can be calculated according to the following equations:

$$VB1 = VAP + VIN \text{ and } VB2 = VAN - VIN$$

Both amplifiers 17, 19 may have a gain of one. Consequently, the positive output voltage VOUTP, the negative output voltage VOUTN and the differential output voltage VOUT can be calculated according to the following equation:

$$VOUTP = VB1 = VAP + VIN,$$

$$VOUTN = VB2 = VAN - VIN$$

and

$$VOUT = VOUTP - VOUTN = VB1 - VB2 = VAP + 2 \cdot VIN - VAN$$

The equations above are valid for each value of the differential input voltage VIN that means for each of the three regions I, II, III defined below. The first phase A and the second phase B alternate. The first to the third converter signals Φ2M, Φ2P, Φ2N are generated by the DA converter 37. The differential gain-stage circuit 10 is configured to perform a differential sampling.

Figures 1C and 1D show exemplary voltages VS that can be tapped in the differential gain-stage circuit 10 described in Figures 1A and 1B. Figures 1C and 1D are diagrams of the signal generation for the first channel 50, namely the p-channel. In Figure 1C, the arrows indicate the difference between the positive input voltage VINP and the negative input voltage VINN. Thus, the arrows indicate the differential input voltage VIN sampled at the first and at the second capacitor 11, 14. The resulting differential input voltage VIN is shown on the x-axes. If the positive input voltage VINP and the negative input voltage VINN are equal, both input voltages VINP, VINN are equal to the common mode voltage VCM. For example, the common mode voltage VCM may be at the half of a supply voltage VDD. Thus, the common mode voltage VCM may be for example equal to 1.65 V. The differential input voltage VIN may have positive and negative values. Thus, the differential input voltage VIN may be for example out of the range from -0.5 V to +0.5 V. The relationship of the positive input voltage VINP, the negative input voltage VINN, the common mode voltage VCM and the differential input voltage VIN is as follows:

$$VINP = VCM + \frac{VIN}{2},$$

$$VINN = VCM - \frac{VIN}{2},$$

$$VIN = VINP - VINN$$

In Figure 1D, the positive output voltage VOUTP and the negative output voltage VOUTN are illustrated as a function of the differential input voltage VIN. The positive output voltage VOUTP and the negative output voltage VOUTN are mirrored to each other with respect to a line representing the common mode voltage VCM. The length of the arrows corresponds to the value of the differential input voltage VIN. In Figure 1D, positive values of the differential input voltage VIN result in bottom-up arrows and negative values of the differential input voltage VIN result in top-down arrows. As indicated in Figures 1C and 1D by two vertical lines the differential input voltage VIN is separated in three regions I, II, III, wherein VTP is a positive threshold voltage and VTN is a negative threshold voltage:

$$\text{First region I: } VTP \leq VIN$$

$$\text{Second region II: } VIN \leq VTN$$

$$\text{Third region III: } VTN \leq VIN \leq VTP$$

In case the differential input voltage VIN is in the first region I, the first converter signal Φ2P is set. In the first region I, the differential output voltage VOUT, the positive output voltage VOUTP and the negative output voltage VOUTN can be calculated according to the following equations:

$$VOUTP = VN + VIN = VCM + VIN - \Delta V,$$

$$VOUTN = VP - VIN = VCM - VIN + \Delta V,$$

$$VOUT = 2 \cdot VIN - 2 \cdot \Delta V;$$

wherein VN is the negative reference voltage, VP is the positive reference voltage, VIN is the differential input voltage and VCM is the common mode voltage. $\Delta V$ can be calculated according to the equation:

$$\Delta V = \frac{VP - VN}{2}$$

In case the differential input voltage VIN has a value in the second region II, the second converter signal Φ2N is set. In the second region II, the differential output voltage VOUT, the positive output voltage VOUTP and the negative output voltage VOUTN can be calculated according to the following equations:

$$VOUTP = VP + VIN = VCM + VIN + \Delta V,$$

$$VOUTN = VN - VIN = VCM - VIN - \Delta V,$$

$$VOUT = 2 \cdot VIN + 2 \cdot \Delta V$$

In case the differential input voltage VIN is in the third region III, the third converter signal Φ2M is set. In the third region II, the differential output voltage VOUT, the positive output voltage VOUTP and the negative output voltage VOUTN can be calculated according to the following equations:

$$VOUTP = VCM + VIN,$$

$$VOUTN = VCM - VIN,$$

$$VOUT = 2 \cdot VIN$$

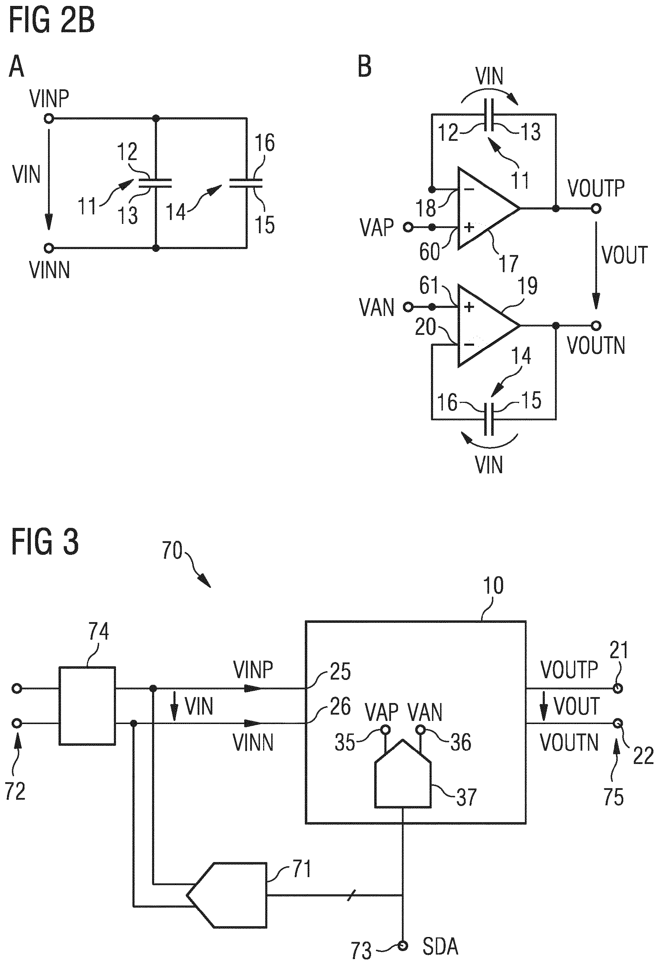

An analog-to-digital converter 71 shown in Figure 3 may generate converter signals Φ2P, Φ2M, Φ2N.
Advantageously, the first and the second capacitor 11, 14 are directly charged with the voltage difference that is the differential input voltage VIN. The voltage difference is between the negative input voltage VINN and the positive input voltage VINP illustrated by arrows in Figure 1C. The differential input voltage VIN is then used to create each of the single ended signals again, namely the negative output voltage VOUTN and the positive output voltage VOUTP. As a result, the differential output voltage VOUT at the two output terminals 21, 22 of the differential gain-stage circuit 10 is then proportional to the differential input voltage VIN. The proportional factor may be a gain factor of approximately two. The differential input voltage VIN is used to generate a gain of two for a MDAC 70 shown in Figure 3. In Figure 1D, the output signals such as the positive and negative output voltage VOUTP, VOUTN are constructed adding the sampled differential input voltage VIN to the appropriate reference voltage, namely the positive or the negative reference voltage VP, VN or the common mode voltage VCM.

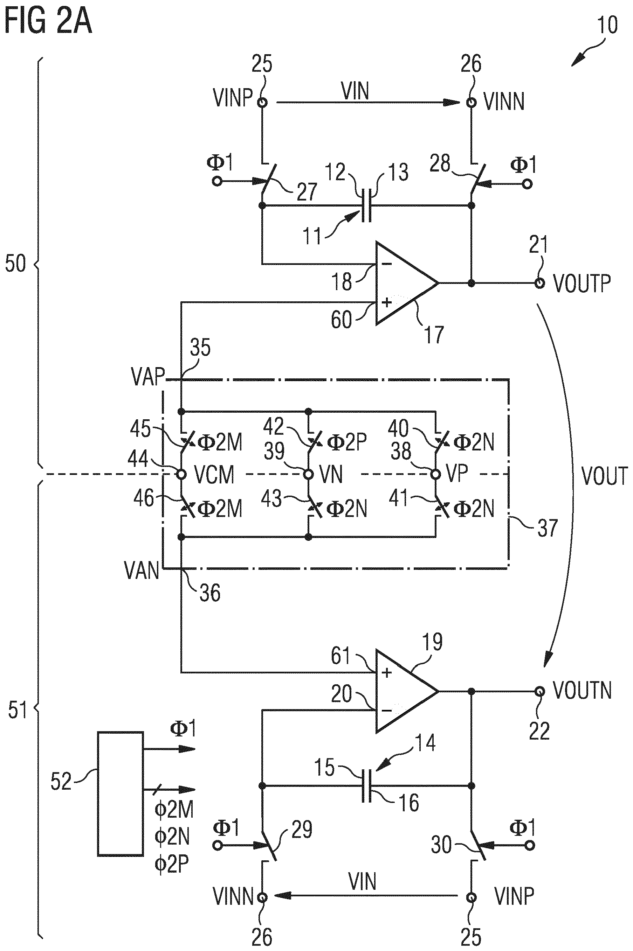

Figure 2A shows a further exemplary embodiment of the differential gain-stage circuit 10 which is a further development of the above shown embodiments. The first and the second amplifier 17, 19 are realized as operational amplifiers. The input 18 of the first amplifier 17 is realized as an inverting input, whereas a further input 60 of the first amplifier 17 is implemented as a non-inverting input. The input 20 of the second amplifier 19 is realized as an inverting input, whereas a further input 61 of the second amplifier 19 is implemented as a non-inverting input.

The first capacitor 11 couples the input 18 of the first amplifier 17 to the output of the first amplifier 17. The second capacitor 14 is arranged between the input 20 of the second amplifier 19 and the output of the second amplifier 19. The first and the second capacitor 11, 14 may be directly and permanently connected to the first and the second amplifier 17, 19. The first electrode 12 of the first capacitor 11 is connected to the input 18 of the first amplifier 17. The second electrode 13 of the first capacitor 11 is connected to the output of the first amplifier 17. Correspondingly, the first electrode 15 of the second capacitor 14 is connected to the input 20 of the second amplifier 19. The second electrode 16 of the second capacitor 14 is connected to the output of the second amplifier 19. The four input switches 27 to 30 may be connected to the first and the second capacitor 11, 14 such as shown in Figure 1A.

The first voltage node 35 is connected to the further input 60 of the first amplifier 17. The second voltage node 36 is connected to the further input 61 of the second amplifier 19. The first adder voltage VAP is provided via the first voltage node 35 to the further input 60 of the first amplifier 17. The second adder voltage VAN is provided via the second voltage node 36 to the further input 61 of the second amplifier 19.

Figure 2B shows exemplary phases of the differential gain-stage circuit 10 shown in Figure 2A. The differential input voltage VIN is sampled at the first and the second capacitor 11, 14 in the first phase A and provided between the input 18, 20 and the output of the first and second amplifier 17, 19 in the second phase B.

Figure 3 shows a multiplying digital-to-analog converter 70, abbreviated MDAC. The MDAC 70 comprises the differential gain-stage circuit 10 as shown in one of the Figures above. Additionally, the MDAC 70 comprises an analog-to-digital converter 71, abbreviated AD converter. The AD converter 71 is designed as sub AD converter. The AD converter 71 may comprise two comparators, not shown. The two comparators may compare the differential input voltage VIN with the positive threshold voltage VTP and the negative threshold voltage VTN. An analog input 72 of the MDAC 70 is coupled to an input of the AD converter 71 and to the positive and the negative input terminal 25, 26. The analog input 72 may be realized as a differential input. An output of the AD converter 71 is coupled to a digital output 73 of the MDAC 70 and to an input of the DA converter 37.

The MDAC 70 may comprise a sample-and-hold circuit 74 coupling the analog input 72 of the MDAC 70 to the AD converter 71 and the positive and negative input terminal 25, 26. The positive and the negative output terminal 21, 22 form an analog output 75 of the MDAC 70. The analog output 75 is implemented as a differential output.

The AD converter 71 generates a digital output signal SDA and provides it to the digital output 73 of the MDAC 70 and to the input of the DA converter 37. The digital output signal SDA may comprise two bits.

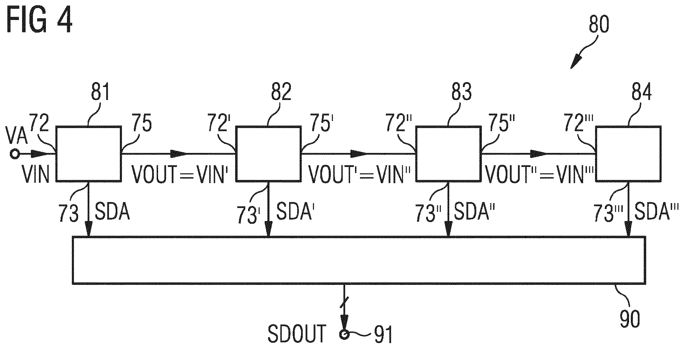

The differential gain-stage circuit 10 is configured for multiplication and summation. A value of the differential output voltage VOUT depends on a value of the differential input voltage VIN and a value of the digital output signal SDA. The value of the differential output voltage VOUT corresponds to the twofold value of the differential input voltage VIN which is added to the value of the digital output signal SDA. The value of the digital output signal SDA corresponds to the voltage difference between the first adder voltage VAP and the second adder voltage VAN. Thus, the differential output voltage VOUT is a residual voltage that is further digitized by a further MDAC as shown in Figure 4. The multiplication is performed with the gain factor of approximately two.

Figure 4 shows an exemplary embodiment of a pipelined AD converter arrangement 80 that comprises the MDAC 70 shown in Figure 3. The pipelined AD converter arrangement 80 comprises the first number N of stages 81 to 84 which are serially connected. The analog output 75 of the first stage 81 is connected to an analog input 72' of the second stage 82 and so on. At least one of the stages 81 to 84 may be implemented as the MDAC 70 shown in Figure 3. Each of the first number N of stages 81 to 84 may be realized as the MDAC 70 shown in Figure 3. The digital output 73 of each of the first number N of stages 81 to 84 is connected to a digital correction circuit 90 of the pipelined AD converter arrangement 80. An output of the digital correction circuit 90 forms a digital output 91 of the pipelined AD converter arrangement 80.

An analog input voltage VA is provided to the input of the first stage 81. A digital converter output signal SDOUT is generated by the use of the digital output signals SDA, SDA', SDA", SDA''' generated by the first number N of stages 81 to 84 especially by the AD converter 71 of the first number N of stages 81 to 84.

Alternatively, the stages of the first number N of stages 81 to 84 may be realized by different circuits. Some stages may be realized as MDAC 70 shown in Figure 3. For example, the first stage 81 may be realized with the sample-and-hold circuit 74. Other stages may be realized without the sample-and-hold circuit 74. The last stage 84 may be implemented without the analog output 75 and without the first and the second amplifier 17, 19.

Reference numerals

| | |
|---|---|
| 10 | differential gain-stage circuit |
| 11 | first capacitor |
| 12 | first electrode |
| 13 | second electrode |
| 14 | second capacitor |
| 15 | first electrode |
| 16 | second electrode |
| 17 | first amplifier |
| 18 | input |
| 19 | second amplifier |
| 20 | input |
| 21 | positive output terminal |
| 22 | negative output terminal |
| 25 | positive input terminal |
| 26 | negative input terminal |
| 27 to 30 | input switch |
| 35 | first voltage node |
| 36 | second voltage node |
| 37 | digital-to-analog converter |
| 38 | positive reference terminal |
| 39 | negative reference terminal |
| 40 to 43 | converter switch |
| 44 | common mode terminal |
| 45, 46 | converter switch |
| 50 | first channel |
| 51 | second channel |
| 52 | control logic |
| 60, 61 | further input |
| 70 | multiplying digital-to-analog converter |
| 71 | analog-to-digital converter |
| 72, 72', 72'' | analog input |
| 73 | digital output |
| 74 | sample-and-hold circuit |
| 75, 75', 75'' | analog output |
| 80 | pipelined analog-to-digital converter arrangement |
| 81 to 84 | stage |
| 90 | digital correction circuit |
| 91 | digital output |
| A | first phase |
| B | second phase |
| SAN | analog input signal |
| SDA | digital output signal |
| SDOUT | digital converter output signal |
| VA | analog input signal |
| VAN | second adder voltage |
| VAP | first adder voltage |
| VB1 | first input voltage |
| VB2 | second input voltage |
| VCM | common mode voltage |
| VIN | differential input voltage |
| VINN | negative input voltage |
| VINP | positive input voltage |
| VOUT | differential output signal |
| VOUTN | negative output voltage |

| VOUTP | positive output voltage |
| VN | negative reference voltage |
| VP | positive reference voltage |
| VTN | negative threshold voltage |
| VTP | positive threshold voltage |
| $\Phi 1$ | first control signal |
| $\Phi 2M$ | third converter signal |
| $\Phi 2N$ | second converter signal |
| $\Phi 2P$ | first converter signal |

**Claims**

1.  A differential gain-stage circuit, comprising

    - a positive and a negative input terminal (25, 26),
    - a first capacitor (11) with a first and a second electrode (12, 13),
    - a second capacitor (14) with a first and a second electrode (15, 16),
    wherein in a first phase (A), the first electrode (12) of the first capacitor (11) and the second electrode (16) of the second capacitor (14) are both connected to the positive input terminal (25) and the second electrode (13) of the first capacitor (11) and the first electrode (15) of the second capacitor (14) are both connected to the negative input terminal (26) and thus in the first phase (A), a parallel circuit of the first and the second capacitor (11, 14) is connected to the positive and the negative input terminal (25, 26),
    - a first amplifier (17) with an input (18), wherein the first electrode (12) of the first capacitor (11) is directly and permanently connected to the input (18) of the first amplifier (17),
    - a second amplifier (19) with an input (20), wherein the first electrode (15) of the second capacitor (14) is directly and permanently connected to the input (20) of the second amplifier (19),
    - a positive output terminal (21) coupled to an output of the first amplifier (17),
    - a negative output terminal (22) coupled to an output of the second amplifier (19),
    - a first voltage node (35) connected to the second electrode (13) of the first capacitor (11), and
    - a second voltage node (36) connected to the second electrode (16) of the second capacitor (14),

    **characterized in**
    **that** the differential gain-stage circuit (10) further comprises a digital-to-analog converter (37) with outputs coupled to the first and the second voltage node (35, 36),
    wherein the digital-to-analog converter (37) is adapted to generate a first and a second adder voltage (VAP, VAN) in a second phase (B), and
    wherein in the second phase (B), the first adder voltage (VAP) is provided to the first voltage node (35) and the second adder voltage (VAN) is provided to the second voltage node (36).

2.  The differential gain-stage circuit according to claim 1,
    wherein the first and the second amplifier (17, 19) are implemented as a first and a second buffer.

3.  The differential gain-stage circuit according to claim 1 or 2, comprising

    - a first input switch (27) coupling the positive input terminal (25) to the first electrode (12) of the first capacitor (11),
    - a second input switch (28) coupling the negative input terminal (26) to the second electrode (13) of the first capacitor (11),
    - a third input switch (29) coupling the negative input terminal (26) to the first electrode (15) of the second capacitor (14), and
    - a fourth input switch (30) coupling the positive input terminal (25) to the second electrode (16) of the second capacitor (14).

4.  The differential gain-stage circuit according to claim 3,
    wherein the first to the fourth input switch (27 to 30) are set in a conducting state in the first phase (A) and in a non-conducting state in a second phase (B).

5.  The differential gain-stage circuit according to one of claims 1 to 4,

wherein the digital-to-analog converter (37) comprises

- a first to a fourth converter switch (40 to 43),
- a positive reference terminal (38) coupled via the first and the second converter switch (40, 41) to the first and the second voltage node (35, 36) and
- a negative reference terminal (39) coupled via the third and the fourth converter switch (42, 43) to the first and the second voltage node (35, 36).

6. The differential gain-stage circuit according to one of claims 1 to 5,
wherein the digital-to-analog converter (37) comprises

- a fifth and a sixth converter switch (45, 46) and
- a common mode terminal (44) coupled via the fifth and the sixth converter switch (45, 46) to the first and the second voltage node (35, 36).

7. The differential gain-stage circuit according to one of claims 1 to 6,
wherein the differential gain-stage circuit (10) realizes a gain factor of approximately two.

8. A multiplying digital-to-analog converter (70), comprising the differential gain-stage circuit (10) according to one of claims 1 to 7 and an analog-to-digital converter (71), wherein an analog input (72) of the multiplying digital-to-analog converter (70) is coupled to the positive and the negative input terminal (25, 26) of the differential gain-stage circuit (10) and to an input of the analog-to-digital converter (71),
wherein an output of the analog-to-digital converter (71) is coupled to an input of the digital-to-analog converter (37) of the differential gain-stage circuit (10) and to a digital output (73) of the multiplying digital-to-analog converter (70), and
wherein the positive and the negative output terminal (21, 22) of the differential gain-stage circuit (10) are coupled to an analog output (75) of the multiplying digital-to-analog converter (70).

9. A pipelined analog-to-digital converter arrangement (80), comprising a first number N of stages (81 to 84),
wherein at least one stage of the first number N of stages (81 to 84) is implemented as the multiplying digital-to-analog converter (70) according to claim 8.

10. A method for multiplying a voltage, comprising

- providing a differential input voltage (VIN) to a parallel circuit of a first capacitor (11) and a second capacitor (14) in a first phase (A) by connecting a first electrode (12) of the first capacitor (11) and a second electrode (16) of the second capacitor (14) both to a positive input terminal (25) and by connecting a second electrode (13) of the first capacitor (11) and a first electrode (15) of the second capacitor (14) both to a negative input terminal (26) in the first phase (A),
wherein the differential input voltage (VIN) is applied to the positive and the negative input terminal (25, 26),
- generating a positive output voltage (VOUTP) by a first amplifier (17) having an input (18), wherein the first electrode (12) of the first capacitor (11) is directly and permanently connected to the input (18) of the first amplifier (17), and
- generating a negative output voltage (VOUTN) by a second amplifier (19) having an input (20), wherein the first electrode (15) of the second capacitor (14) is directly and permanently connected to the input (20) of the second amplifier (19),

wherein a first voltage node (35) is connected to the second electrode (13) of the first capacitor (11) and a second voltage node (36) is connected to the second electrode (16) of the second capacitor (14),
**characterized in**
**that** the method further comprises

- generating a first and a second adder voltage (VAP, VAN) by a digital-to-analog converter (37) in a second phase (B), and
- providing the first adder voltage (VAP) to the first voltage node (35) and the second adder voltage (VAN) to the second voltage node (36) in the second phase (B).

11. The method for multiplying a voltage according to claim 10,

wherein a first adder voltage (VAP) is provided to the second electrode (13) of the first capacitor (11) and a second adder voltage (VAN) is provided to the second electrode (16) of the second capacitor (14) in a second phase (B).

12. A differential gain-stage circuit, comprising

- a positive and a negative input terminal (25, 26),
- a first capacitor (11) with a first and a second electrode (12, 13), and
- a second capacitor (14) with a first and a second electrode (15, 16),
wherein in a first phase (A), the first electrode (12) of the first capacitor (11) and the second electrode (16) of the second capacitor (14) are both connected to the positive input terminal (25) and the second electrode (13) of the first capacitor (11) and the first electrode (15) of the second capacitor (14) are both connected to the negative input terminal (26) and thus in the first phase (A), a parallel circuit of the first and the second capacitor (11, 14) is connected to the positive and the negative input terminal (25, 26),
- a first amplifier (17), wherein the first electrode (12) of the first capacitor (11) is directly and permanently connected to an input (18) of the first amplifier (17),
- a second amplifier (19), wherein the first electrode (15) of the second capacitor (14) is directly and permanently connected to an input (20) of the second amplifier (19),
- a positive output terminal (21) coupled to an output of the first amplifier (17), and
- a negative output terminal (22) coupled to an output of the second amplifier (19),

**characterized in**
**that** the differential gain-stage circuit (10) further comprises

- a first voltage node (35) connected to a further input (60) of the first amplifier (17),
- a second voltage node (36) connected to a further input (61) of the second amplifier (19), and
- a digital-to-analog converter (37) with outputs coupled to the first and the second voltage node (35, 36),

wherein the digital-to-analog converter (37) is adapted to generate a first and a second adder voltage (VAP, VAN) in a second phase (B), and
wherein the first adder voltage (VAP) is provided via the first voltage node (35) to the further input (60) of the first amplifier (17) and the second adder voltage (VAN) is provided via the second voltage node (36) to the further input (61) of the second amplifier (19).

13. A method for multiplying a voltage, comprising

- providing a differential input voltage (VIN) to a parallel circuit of a first capacitor (11) and a second capacitor (14) in a first phase (A) by connecting a first electrode (12) of the first capacitor (11) and a second electrode (16) of the second capacitor (14) both to a positive input terminal (25) and by connecting a second electrode (13) of the first capacitor (11) and a first electrode (15) of the second capacitor (14) both to a negative input terminal (26) in the first phase (A),
wherein the differential input voltage (VIN) is applied to the positive and the negative input terminal (25, 26),
- generating a positive output voltage (VOUTP) by a first amplifier (17), wherein the first electrode (12) of the first capacitor (11) is directly and permanently connected to an input (18) of the first amplifier (17), and
- generating a negative output voltage (VOUTN) by a second amplifier (19), wherein the first electrode (15) of the second capacitor (14) is directly and permanently connected to an input (20) of the second amplifier (19),

**characterized in**
**that** the method further comprises

- generating a first and a second adder voltage (VAP, VAN) by a digital-to-analog converter (37) in a second phase (B), and
- providing the first adder voltage (VAP) via a first voltage node (35) to a further input (60) of the first amplifier (17), and
- providing the second adder voltage (VAN) via a second voltage node (36) to a further input (61) of the second amplifier (19).

**Patentansprüche**

1.  Eine Differentialverstärkungsstufenschaltung, aufweisend

    - einen positiven und einen negativen Eingangsanschluss (25, 26),
    - einen ersten Kondensator (11) mit einer ersten und einer zweiten Elektrode (12, 13),
    - einen zweiten Kondensator (14) mit einer ersten und einer zweiten Elektrode (15, 16),
    wobei in einer ersten Phase (A) die erste Elektrode (12) des ersten Kondensators (11) und die zweite Elektrode (16) des zweiten Kondensators (14) jeweils mit dem positiven Eingangsanschluss (25) verbunden ist und die zweite Elektrode (13) des ersten Kondensators (11) und die erste Elektrode (15) des zweiten Kondensators (14) jeweils mit dem negativen Eingangsanschluss (26) verbunden ist, und damit in der ersten Phase (A) eine Parallelschaltung des ersten und zweiten Kondensators (11, 14) mit dem positiven und dem negativen Eingangsanschluss (25, 26) verbunden ist,
    - einen ersten Verstärker (17) mit einem Eingang (18), wobei die erste Elektrode (12) des ersten Kondensators (11) direkt und dauerhaft mit dem Eingang (18) des ersten Verstärkers (17) verbunden ist,
    - einen zweiten Verstärker (19) mit einem Eingang (20), wobei die erste Elektrode (15) des zweiten Kondensators (14) direkt und dauerhaft mit dem Eingang (20) des zweiten Verstärkers (19) verbunden ist,
    - einen positiven Ausgangsanschluss (21), der mit einem Ausgang des ersten Verstärkers (17) gekoppelt ist,
    - einen negativen Ausgangsanschluss (22), der mit einem Ausgang des zweiten Verstärkers (19) gekoppelt ist,
    - einen ersten Spannungsknoten (35), der mit der zweiten Elektrode (13) des ersten Kondensators (11) verbunden ist, und
    - einen zweiten Spannungsknoten (36), der mit der zweiten Elektrode (16) des zweiten Kondensators (14) verbunden ist,

    **dadurch gekennzeichnet, dass**
    die Differentialverstärkungsstufenschaltung (10) ferner einen Digital/Analog-Wandler (37) mit Ausgängen aufweist, die mit dem ersten und dem zweiten Spannungsknoten (35, 36) gekoppelt sind,
    wobei der Digital/Analog-Wandler (37) dazu angepasst ist, eine erste und eine zweite Addiererspannung (VAP, VAN) in einer zweiten Phase (B) zu erzeugen, und
    wobei in der zweiten Phase (B) die erste Addiererspannung (VAP) dem ersten Spannungsknoten (35) und die zweite Addiererspannung (VAN) dem zweiten Spannungsknoten (36) bereitgestellt wird.

2.  Die Differentialverstärkungsstufenschaltung nach Anspruch 1,
    wobei der erste und der zweite Verstärker (17, 19) als ein erster und ein zweiter Puffer implementiert sind.

3.  Die Differentialverstärkungsstufenschaltung nach Anspruch 1 oder 2, aufweisend

    - einen ersten Eingangsschalter (27), der den positiven Eingangsanschluss (25) mit der ersten Elektrode (12) des ersten Kondensators (11) koppelt,
    - einen zweiten Eingangsschalter (28), der den negativen Eingangsanschluss (26) mit der zweiten Elektrode (13) des ersten Kondensators (11) koppelt,
    - einen dritten Eingangsschalter (29), der den negativen Eingangsanschluss (26) mit der ersten Elektrode (15) des zweiten Kondensators (14) koppelt, und
    - einen vierten Eingangsschalter (30), der den positiven Eingangsanschluss (25) mit der zweiten Elektrode (16) des zweiten Kondensators (14) koppelt.

4.  Die Differentialverstärkungsstufenschaltung nach Anspruch 3,
    wobei der erste bis vierte Eingangsschalter (27 bis 30) in der ersten Phase (A) in einen leitenden Zustand und in der zweiten Phase (B) in einen nichtleitenden Zustand versetzt sind.

5.  Die Differentialverstärkungsstufenschaltung nach einem der Ansprüche 1 bis 4,
    wobei der Digital/Analog-Wandler (37) aufweist:

    - einen ersten bis vierten Wandlerschalter (40 bis 43),
    - einen positiven Referenzanschluss (38), der über den ersten und zweiten Wandlerschalter (40, 41) mit dem ersten und zweiten Spannungsknoten (35, 36) gekoppelt ist, und
    - einen negativen Referenzanschluss (39), der über den dritten und vierten Wandlerschalter (42, 43) mit dem ersten und zweiten Spannungsknoten (35, 36) gekoppelt ist.

**6.** Die Differentialverstärkungsstufenschaltung nach einem der Ansprüche 1 bis 5,
wobei der Digital/Analog-Wandler (37) aufweist:

- einen fünften und einen sechsten Wandlerschalter (45, 46) und
- einen Gleichtaktanschluss (44), der über den fünften und sechsten Wandlerschalter (45, 46) mit dem ersten und zweiten Spannungsknoten (35, 36) gekoppelt ist.

**7.** Die Differentialverstärkungsstufenschaltung nach einem der Ansprüche 1 bis 6,
wobei die Differentialverstärkungsstufenschaltung (10) einen Verstärkungsfaktor von etwa Zwei erzielt.

**8.** Ein multiplizierender Digital/Analog-Wandler (70),
die Differentialverstärkungsstufenschaltung (10) nach einem der Ansprüche 1 bis 7 und einen Analog/Digital-Wandler (71) aufweisend, wobei ein analoger Eingang (72) des multiplizierenden Digital/Analog-Wandlers (70) mit dem positiven und negativen Eingangsanschluss (25, 26) der Differentialverstärkungsstufenschaltung (10) und mit einem Eingang des Analog/Digital-Wandlers (71) gekoppelt ist,
wobei ein Ausgang des Analog/Digital-Wandlers (71) mit einem Eingang des Digital/Analog-Wandlers (37) der Differentialverstärkungsstufenschaltung (10) und mit einem digitalen Ausgang (73) des multiplizierenden Digital/Analog-Wandlers (70) gekoppelt ist, und
wobei der positive und negative Ausgangsanschluss (21, 22) der Differentialverstärkungsstufenschaltung (10) mit einem analogen Ausgang (15) des multiplizierenden Digital/Analog-Wandlers (70) gekoppelt sind.

**9.** Eine pipeline-artige Analog/Digital-Wandleranordnung (80), aufweisend eine erste Anzahl N von Stufen (81 bis 84), wobei mindestens eine Stufe der ersten Anzahl N der Stufen (81 bis 84) als der multiplizierende Digital/Analog-Wandler (70) nach Anspruch 8 implementiert ist.

**10.** Ein Verfahren zum Multiplizieren einer Spannung, umfassend:

- Anlegen einer differentiellen Eingangsspannung (VIN) an einer Parallelschaltung eines ersten Kondensators (11) und eines zweiten Kondensators (14) in einer ersten Phase (A) durch Verbinden einer ersten Elektrode (12) des ersten Kondensators (11) und einer zweiten Elektrode (16) des zweiten Kondensators (14) jeweils mit einem positiven Eingangsanschluss (25) und durch Verbinden einer zweiten Elektrode (13) des ersten Kondensators (11) und einer ersten Elektrode (15) des zweiten Kondensators (14) jeweils mit einem negativen Eingangsanschluss (26) in der ersten Phase (A),
wobei die differentielle Eingangsspannung (VIN) an den positiven und negativen Eingangsanschluss (25, 26) angelegt wird,
- Erzeugen einer positiven Ausgangsspannung (VOUTP) durch einen ersten Verstärker (17) mit einem Eingang (18), wobei die erste Elektrode (12) des ersten Kondensators (11) direkt und dauerhaft mit dem Eingang (18) des ersten Verstärkers (17) verbunden ist, und
- Erzeugen einer negativen Ausgangsspannung (VOUTN) durch einen zweiten Verstärker (19) mit einem Eingang (20), wobei die erste Elektrode (15) des zweiten Kondensators (14) direkt und dauerhaft mit dem Eingang (20) des zweiten Verstärkers (19) verbunden ist,

wobei ein erster Spannungsknoten (35) mit der zweiten Elektrode (13) des ersten Kondensators (11) verbunden ist und ein zweiter Spannungsknoten (36) mit der zweiten Elektrode (16) des zweiten Kondensators (14) verbunden ist,
**dadurch gekennzeichnet, dass**
das Verfahren ferner aufweist:

- Erzeugen einer ersten und einer zweiten Addiererspannung (VAP, VAN) durch einen Digital/Analog-Wandler (37) in einer zweiten Phase (B), und
- Anlegen der ersten Addiererspannung (VAP) an den ersten Spannungsknoten (35) und der zweiten Addiererspannung (VAN) an den zweiten Spannungsknoten (36) in der zweiten Phase (B).

**11.** Das Verfahren zum Multiplizieren einer Spannung nach Anspruch 10,
wobei eine erste Addiererspannung (VAP) an die zweite Elektrode (13) des ersten Kondensators (11) und eine zweite Addiererspannung (VAN) an die zweite Elektrode (16) des zweiten Kondensators (14) in der zweiten Phase (B) angelegt wird.

**12.** Eine Differentialverstärkungsstufenschaltung, aufweisend

- einen positiven und einen negativen Eingangsanschluss (25, 26),
- einen ersten Kondensator (11) mit einer ersten und einer zweiten Elektrode (12, 13) und
- einen zweiten Kondensator (14) mit einer ersten und einer zweiten Elektrode (15, 16),
wobei in einer ersten Phase (A) die erste Elektrode (12) des ersten Kondensators (11) und die zweite Elektrode (16) des zweiten Kondensators (14) jeweils mit dem positiven Eingangsanschluss (25) verbunden ist und die zweite Elektrode (13) des ersten Kondensators (11) und die erste Elektrode (15) des zweiten Kondensators (14) jeweils mit dem negativen Eingangsanschluss (26) verbunden ist, und somit in der ersten Phase (A) eine Parallelschaltung des ersten und zweiten Kondensators (11, 14) mit dem positiven und negativen Eingangsanschluss (25, 26) verbunden ist,
- einen ersten Verstärker (17), wobei die erste Elektrode (12) des ersten Kondensators (11) direkt und dauerhaft mit einem Eingang (18) des ersten Verstärkers (17) verbunden ist,
- einen zweiten Verstärker (19), wobei die erste Elektrode (15) des zweiten Kondensators (14) direkt und dauerhaft mit einem Eingang (20) des zweiten Verstärkers (19) verbunden ist,
- einen positiven Ausgangsanschluss (21), der mit einem Ausgang des ersten Verstärkers (17) gekoppelt ist, und
- einen negativen Ausgangsanschluss (22), der mit einem Ausgang des zweiten Verstärkers (19) gekoppelt ist,

**dadurch gekennzeichnet, dass**
die Differentialverstärkungsstufenschaltung (10) ferner aufweist:

- einen ersten Spannungsknoten (35), der mit einem weiteren Eingang (60) des ersten Verstärkers (17) verbunden ist,
- einen zweiten Spannungsknoten (36), der mit einem weiteren Eingang (61) des zweiten Verstärkers (19) verbunden ist, und
- einen Digital/Analog-Wandler (37) mit Ausgängen, die mit dem ersten und zweiten Spannungsknoten (35, 36) gekoppelt sind,

wobei der Digital/Analog-Wandler (37) dazu angepasst ist, eine erste und eine zweite Addiererspannung (VAP, VAN) in einer zweiten Phase (B) zu erzeugen, und
wobei die erste Addiererspannung (VAP) über den ersten Spannungsknoten (35) dem weiteren Eingang (60) des ersten Verstärkers (17) bereitgestellt wird und die zweite Addiererspannung (VAN) über den zweiten Spannungsknoten (36) dem weiteren Eingang (61) des zweiten Verstärkers (19) bereitgestellt wird.

13. Ein Verfahren zum Multiplizieren einer Spannung, umfassend:

- Anlegen einer differentiellen Eingangsspannung (VIN) an eine Parallelschaltung eines ersten Kondensators (11) und eines zweiten Kondensators (14) in einer ersten Phase (A) durch Verbinden einer ersten Elektrode (12) des ersten Kondensators (11) und einer zweiten Elektrode (16) des zweiten Kondensators (14) jeweils mit einem positiven Eingangsanschluss (25) und durch Verbinden einer zweiten Elektrode (13) des ersten Kondensators (11) und einer ersten Elektrode (15) des zweiten Kondensators (14) jeweils mit einem negativen Eingangsanschluss (26) in der ersten Phase (A),
wobei die differentielle Eingangsspannung (VIN) an den positiven und negativen Eingangsanschluss (25, 26) angelegt wird,
- Erzeugen einer positiven Ausgangsspannung (VOUTP) durch einen ersten Verstärker (17), wobei die erste Elektrode (12) des ersten Kondensators (11) direkt und dauerhaft mit einem Eingang (18) des ersten Verstärkers (17) verbunden ist, und
- Erzeugen einer negativen Ausgangsspannung (VOUTN) durch einen zweiten Verstärker (19), wobei die erste Elektrode (15) des zweiten Kondensators (14) direkt und dauerhaft mit einem Eingang (20) des zweiten Verstärkers (19) verbunden ist,

**dadurch gekennzeichnet, dass**
das Verfahren ferner aufweist:

- Erzeugen einer ersten und einer zweiten Addiererspannung (VAP, VAN) durch einen Digital/Analog-Wandler (37) in einer zweiten Phase (B), und
- Anlegen der ersten Addiererspannung (VAP) über einen ersten Spannungsknoten (35) an einen weiteren Eingang (60) des ersten Verstärkers (17), und
- Anlegen der zweiten Addiererspannung (VAN) über einen zweiten Spannungsknoten (36) an einen weiteren Eingang (61) des zweiten Verstärkers (19).

**Revendications**

1. Un circuit à étage de gain différentiel, comprenant

   - des bornes d'entrée positive et négative (25, 26),
   - un premier condensateur (11) avec une première et une deuxième électrode (12, 13),
   - un deuxième condensateur (14) avec une première et une deuxième électrode (15, 16),
   sachant que dans une première phase (A), la première électrode (12) du premier condensateur (11) et la deuxième électrode (16) du deuxième condensateur (14) sont toutes deux connectées à la borne d'entrée positive (25) et la deuxième électrode (13) du premier condensateur (11) et la première électrode (15) du deuxième condensateur (14) sont toutes deux connectées à la borne d'entrée négative (26) et de la sorte dans la première phase (A), un circuit parallèle du premier et du deuxième condensateur (11, 14) est connecté aux bornes d'entrée positive et négative (25, 26),
   - un premier amplificateur (17) avec une entrée (18), sachant que la première électrode (12) du premier condensateur (11) est connectée de manière directe et permanente à l'entrée (18) du premier amplificateur (17),
   - un deuxième amplificateur (19) avec une entrée (20), sachant que la première électrode (15) du deuxième condensateur (14) est connectée de manière directe et permanente à l'entrée (20) du deuxième amplificateur (19),
   - une borne de sortie positive (21) couplée à une sortie du premier amplificateur (17),
   - une borne de sortie négative (22) couplée à une sortie du deuxième amplificateur (19),
   - un premier nœud de tension (35) connecté à la deuxième électrode (13) du premier condensateur (11), et
   - un deuxième nœud de tension (36) connecté à la deuxième électrode (16) du deuxième condensateur (14),

   **caractérisé en ce que**
   le circuit à étage de gain différentiel (10) comprend en outre un convertisseur numérique-analogique (37) avec des sorties couplées au premier et au deuxième nœud de tension (35, 36),
   sachant que le convertisseur numérique-analogique (37) est apte à générer une première et une deuxième tension d'additionneur (VAP, VAN) dans une deuxième phase (B), et sachant que dans la deuxième phase (B), la première tension d'additionneur (VAP) est fournie au premier nœud de tension (35) et la deuxième tension d'additionneur (VAN) est fournie au deuxième nœud de tension (36).

2. Le circuit à étage de gain différentiel selon la revendication 1,
   sachant que le premier et le deuxième amplificateur (17, 19) sont implémentés comme premier et deuxième tampon.

3. Le circuit à étage de gain différentiel selon la revendication 1 ou 2, comprenant

   - un premier commutateur d'entrée (27) couplant la borne d'entrée positive (25) à la première électrode (12) du premier condensateur (11),
   - un deuxième commutateur d'entrée (28) couplant la borne d'entrée négative (26) à la deuxième électrode (13) du premier condensateur (11),
   - un troisième commutateur d'entrée (29) couplant la borne d'entrée négative (26) à la première électrode (15) du deuxième condensateur (14), et
   - un quatrième commutateur d'entrée (30) couplant la borne d'entrée positive (25) à la deuxième électrode (16) du deuxième condensateur (14).

4. Le circuit à étage de gain différentiel selon la revendication 3,
   sachant que le premier au quatrième commutateur d'entrée (27 à 30) sont mis dans un état conducteur dans la première phase (A) et dans un état non conducteur dans une deuxième phase (B) .

5. Le circuit à étage de gain différentiel selon l'une des revendications 1 à 4,
   sachant que le convertisseur numérique-analogique (37) comprend

   - un premier à un quatrième commutateur de convertisseur (40 à 43),
   - une borne de référence positive (38) couplée via le premier et le deuxième commutateur de convertisseur (40, 41) au premier et au deuxième nœud de tension (35, 36) et
   - une borne de référence négative (39) couplée via le troisième et le quatrième commutateur de convertisseur (42, 43) au premier et au deuxième nœud de tension (35, 36) .

6. Le circuit à étage de gain différentiel selon l'une des revendications 1 à 5,
sachant que le convertisseur numérique-analogique (37) comprend

- un cinquième et un sixième commutateur de convertisseur (45, 46) et
- une borne de mode commun (44) couplée via le cinquième et le sixième commutateur de convertisseur (45, 46) au premier et au deuxième nœud de tension (35, 36).

7. Le circuit à étage de gain différentiel selon l'une des revendications 1 à 6,
sachant que le circuit à étage de gain différentiel (10) réalise un facteur de gain d'approximativement deux.

8. Un convertisseur numérique-analogique multiplicateur (70), comprenant le circuit à étage de gain différentiel (10) selon l'une des revendications 1 à 7 et un convertisseur analogique-numérique (71), sachant qu'une entrée analogique (72) du convertisseur numérique-analogique multiplicateur (70) est couplée aux bornes d'entrée positive et négative (25, 26) du circuit à étage de gain différentiel (10) et à une entrée du convertisseur analogique-numérique (71), sachant qu'une sortie du convertisseur analogique-numérique (71) est couplée à une entrée du convertisseur numérique-analogique (37) du circuit à étage de gain différentiel (10) et à une sortie numérique (73) du convertisseur numérique-analogique multiplicateur (70), et
sachant que les bornes de sortie positive et négative (21, 22) du circuit à étage de gain différentiel (10) sont couplées à une sortie analogique (75) du convertisseur numérique-analogique multiplicateur (70).

9. Un agencement de convertisseur analogique-numérique raccordé (80),
comprenant un premier nombre N d'étages (81 à 84),
sachant qu'au moins un étage du premier nombre N d'étages (81 à 84) est implémenté en tant que le convertisseur numérique-analogique multiplicateur (70) selon la revendication 8.

10. Un procédé de multiplication d'une tension, comprenant

- la fourniture d'une tension d'entrée différentielle (VIN) à un circuit parallèle d'un premier condensateur (11) et d'un deuxième condensateur (14) dans une première phase (A) en connectant une première électrode (12) du premier condensateur (11) et une deuxième électrode (16) du deuxième condensateur (14) toutes deux à une borne d'entrée positive (25) et en connectant une deuxième électrode (13) du premier condensateur (11) et une première électrode (15) du deuxième condensateur (14) toutes deux à une borne d'entrée négative (26) dans la première phase (A),

sachant que la tension d'entrée différentielle (VIN) est appliquée aux bornes d'entrée positive et négative (25, 26),

- la génération d'une tension de sortie positive (VOUTP) par un premier amplificateur (17) ayant une entrée (18), sachant que la première électrode (12) du premier condensateur (11) est connectée de manière directe et permanente à l'entrée (18) du premier amplificateur (17), et
- la génération d'une tension de sortie négative (VOUTN) par un deuxième amplificateur (19) ayant une entrée (20), sachant que la première électrode (15) du deuxième condensateur (14) est connectée de manière directe et permanente à l'entrée (20) du deuxième amplificateur (19), sachant qu'un premier nœud de tension (35) est connecté à la deuxième électrode (13) du premier condensateur (11) et un deuxième nœud de tension (36) est connecté à la deuxième électrode (16) du deuxième condensateur (14),

**caractérisé en ce que**
le procédé comprend en outre

- la génération d'une première et d'une deuxième tension d'additionneur (VAP, VAN) par un convertisseur numérique-analogique (37) dans une deuxième phase (B), et
- la fourniture de la première tension d'additionneur (VAP) au premier nœud de tension (35) et de la deuxième tension d'additionneur (VAN) au deuxième nœud de tension (36) dans la deuxième phase (B).

11. Le procédé de multiplication d'une tension selon la revendication 10,
sachant qu'une première tension d'additionneur (VAP) est fournie à la deuxième électrode (13) du premier condensateur (11) et une deuxième tension d'additionneur (VAN) est fournie à la deuxième électrode (16) du deuxième condensateur (14) dans une deuxième phase (B).

**12.** Un circuit à étage de gain différentiel, comprenant

- des bornes d'entrée positive et négative (25, 26),
- un premier condensateur (11) avec une première et une deuxième électrode (12, 13), et
- un deuxième condensateur (14) avec une première et une deuxième électrode (15, 16),

sachant que dans une première phase (A), la première électrode (12) du premier condensateur (11) et la deuxième électrode (16) du deuxième condensateur (14) sont toutes deux connectées à la borne d'entrée positive (25) et la deuxième électrode (13) du premier condensateur (11) et la première électrode (15) du deuxième condensateur (14) sont toutes deux connectées à la borne d'entrée négative (26) et de la sorte dans la première phase (A), un circuit parallèle du premier et du deuxième condensateur (11, 14) est connecté aux bornes d'entrée positive et négative (25, 26),

- un premier amplificateur (17), sachant que la première électrode (12) du premier condensateur (11) est connectée de manière directe et permanente à une entrée (18) du premier amplificateur (17),
- un deuxième amplificateur (19), sachant que la première électrode (15) du deuxième condensateur (14) est connectée de manière directe et permanente à une entrée (20) du deuxième amplificateur (19),
- une borne de sortie positive (21) couplée à une sortie du premier amplificateur (17), et
- une borne de sortie négative (22) couplée à une sortie du deuxième amplificateur (19)

**caractérisé en ce que**
le circuit à étage de gain différentiel (10) comprend en outre

- un premier nœud de tension (35) connecté à une entrée (60) supplémentaire du premier amplificateur (17),
- un deuxième nœud de tension (36) connecté à une entrée (61) supplémentaire du deuxième amplificateur (19), et
- un convertisseur numérique-analogique (37) avec des sorties couplées au premier et au deuxième nœud de tension (35, 36),

sachant que le convertisseur numérique-analogique (37) est apte à générer une première et une deuxième tension d'additionneur (VAP, VAN) dans une deuxième phase (B), et sachant que la première tension d'additionneur (VAP) est fournie via le premier nœud de tension (35) à l'entrée (60) supplémentaire du premier amplificateur (17) et la deuxième tension d'additionneur (VAN) est fournie via le deuxième nœud de tension (36) à l'entrée (61) supplémentaire du deuxième amplificateur (19).

**13.** Un procédé de multiplication d'une tension, comprenant

- la fourniture d'une tension d'entrée différentielle (VIN) à un circuit parallèle d'un premier condensateur (11) et d'un deuxième condensateur (14) dans une première phase (A) en connectant une première électrode (12) du premier condensateur (11) et une deuxième électrode (16) du deuxième condensateur (14) toutes deux à une borne d'entrée positive (25) et en connectant une deuxième électrode (13) du premier condensateur (11) et une première électrode (15) du deuxième condensateur (14) toutes deux à une borne d'entrée négative (26) dans la première phase (A),

sachant que la tension d'entrée différentielle (VIN) est appliquée aux bornes d'entrée positive et négative (25, 26),

- la génération d'une tension de sortie positive (VOUTP) par un premier amplificateur (17), sachant que la première électrode (12) du premier condensateur (11) est connectée de manière directe et permanente à une entrée (18) du premier amplificateur (17), et
- la génération d'une tension de sortie négative (VOUTN) par un deuxième amplificateur (19), sachant que sachant que la première électrode (15) du deuxième condensateur (14) est connectée de manière directe et permanente à une entrée (20) du deuxième amplificateur (19),

**caractérisé en ce que**
le procédé comprend en outre

- la génération d'une première et d'une deuxième tension d'additionneur (VAP, VAN) par un convertisseur numérique-analogique (37) dans une deuxième phase (B), et

- la fourniture de la première tension d'additionneur (VAP) via un premier nœud de tension (35) à une entrée (60) supplémentaire du premier amplificateur (17), et
- la fourniture de la deuxième tension d'additionneur (VAN) via un deuxième nœud de tension (36) à une entrée (61) supplémentaire du premier amplificateur (19).

# FIG 1A

# FIG 1B

FIG 1C

FIG 1D

# FIG 2A

FIG 2B

A

VINP

VIN

12

11
13     14

16

15

VINN

B

VIN

12          13

18          11

VAP     60     +

17

VOUTP

VOUT

VAN     61     +
19

20          −

VOUTN

14

16          15

VIN

FIG 3

70

10

74

VINP     25

VIN

VINN     26

VAP  VAN

35          36

37

VOUTP     21

VOUT

VOUTN     22

75

72

71

73     SDA

FIG 4

80

81　　　　82　　　　83　　　　84

VA 72　　75　　72'　　75'　　72"　　75"　　72'''

VIN　　VOUT=VIN'　　VOUT'=VIN"　　VOUT"=VIN'''

73　SDA　　73'　SDA'　　73"　SDA"　　73'''　SDA'''

90

SDOUT　　91

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100237710 A1
- US 8299837 B1
- US 7724063 B1
- JP 2013207697 A